(19) Europäisches Patentamt
European Patent Office
Office européen des brevets

(11) Publication number: **0 081 323**
**A1**

(12) # EUROPEAN PATENT APPLICATION

(21) Application number: 82306293.0

(22) Date of filing: 25.11.82

(51) Int. Cl.³: H 01 B 1/22
C 09 D 11/00, C 09 D 5/24
H 05 K 3/12

(30) Priority: 08.12.81 GB 8136941

(43) Date of publication of application:
15.06.83 Bulletin 83/24

(84) Designated Contracting States:
DE FR GB IT NL SE

(71) Applicant: JOHNSON MATTHEY PUBLIC LIMITED COMPANY
43 Hatton Garden
London, EC1N 8EE(GB)

(72) Inventor: Embury, Leslie Douglas
7 High Street
Puckeridge Hertfordshire(GB)

(74) Representative: Hartley, David et al,
c/o Withers & Rogers 4 Dyer's Buildings Holborn
London, EC1N 2JT(GB)

(54) **Curable ink or paint containing electrically conductive metal particles.**

(57) A curable ink or paint containing at least 8% by volume of electrically conductive metal particles so that on curing the ink or paint becomes electrically conductive wherein in order that the ink or paint may be curable by means of uv light the particles are chosen to have a specified shape and size and the ink or paint includes a photosensitiser (such as an amine, nitro or oxo compound) which is excited by uv light and an activator which is decomposed by the excited photosensitiser to produce free radicals which cure the ink or paint. The photosensitiser transmits energy from the uv light into the inner regions of the ink or paint so avoiding the light-screening effect of the metal particles. Also components an circuitry comprising the electrically conductive cured ink or paint.

EP 0 081 323 A1

# CURABLE INK OR PAINT CONTAINING ELECTRICALLY CONDUCTIVE METAL PARTICLES

This invention relates to a curable ink or paint containing electrically conductive metal particles which render the cured ink or paint electrically conductive. The invention also relates to the electrically conductive cured ink or paint and to electrically conductive components and circuitry comprising the cured ink or paint.

Curable inks or paints of this type are used in the manufacture of for example heating elements for vehicle windows,

membrane switches, circuit components for use in for example potentiometers or electro-optic displays or printed circuitry in general. The inks or paints comprise a high concentration (8% by volume of the ink or paint) of electrically conductive metal particles dispersed in one or more organic prepolymers which are curable under the action of free radicals to produce a form-stable electrically conductive cured ink or paint. The high concentration of metal particles is essential to ensure that even when well dispersed, the metal particles are sufficiently mutually adjacent (preferably contiguous) to render the cured ink or paint electrically conductive by providing conductive pathways through the cured ink or paint. Hitherto the ink or paint has usually comprised a thermally decomposable activator which on heating decomposes to generate free radicals so that the ink or paint can be cured by heating. In practice heating can only be done slowly and with careful control of temperature otherwise the organic prepolymers scorch. Attempts have been made to cure the ink or paint by means of ultra violet light which presents no serious risk of scorching and which in theory offers a faster cure. However the minimum concentration of metal particles needed to ensure electrical conductivity is more than sufficient to screen all but the surface of the ink or paint from the curing action of the ultra violet light.

An object of this invention is to provide a curable ink or paint comprising at least 8% by volume of metal particles which can be cured by means of ultra violet light to produce an electrically conductive cured ink or paint.

Accordingly this invention provides a curable ink or paint comprising at least 8% (preferably 10 to 26%) by volume (based on the volume of the uncured ink or paint) of electrically conductive metal particles dispersed in one or more organic prepolymers which are curable by means of free radicals to produce an electrically conductive cured ink or paint wherein

(a) the metal particles have a thickness of less than 1 µm, a maximum dimension of less than 30 µm and not more than 10% by number of the flakes have a maximum dimension of above 20 µm,

(b) the ink or paint also comprises a photosensitiser which is reversibly convertible to an excited state on irradiation by ultra violet light and

(c) the ink or paint also comprises an activator which can be caused to create free radicals by the presence of the reversibly excited photosensitiser, whereby irradiation of the ink or paint with ultra violet light excites the

photosensitiser causing the activator to create free radicals which cure the prepolymer.

Preferably the metal particles are in the form of flakes.

Photosensitiser in the surface regions of the ink or paint receives energy from incident ultra violet light and it was discovered that provided the metal flakes were of suitably small dimensions, the received energy was transmitted around the flakes and into inner regions of the ink or paint so overcoming the screening problem posed by metal particles. It was discovered that free radical activity was generated throughout the ink or paint so that curing was not confined to the surface regions.

Typical photosensitisers include amines or nitro or oxo compounds. Aromatic photoinitiators are preferred. Oxo compounds are less likely to discolour the ink or paint and usually have better dark-stabilities especially when acrylate prepolymers are used. Good transmission of energy occurs if the oxo group is attached to an aromatic ring free from groups (for example hydroxy groups ortho to the oxo group) which stabilise an excited state. Suitable aromatic ketones include:

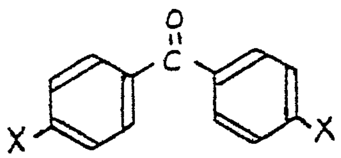

where X is H or $-N(CH_3)_2$

ie Benzophenone or Michler's ketone

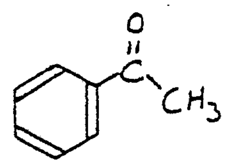

Acetophenone or alternatively α,α-dichloro-p-phenoxy acetophenone

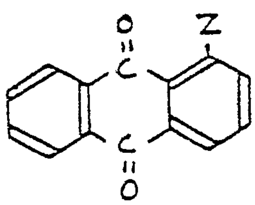

where Z is H or $C_2H_5-$ ie 9,10-anthraquinone or Ethyl-9,10-anthraquinone

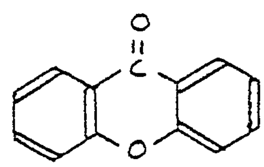

Xanthone or alternatively Thioxanthone, Ethylthioxanthone, Dodecylthioxanthone, isopropylthioxanthone or 2-chlorothioxanthone may be used.

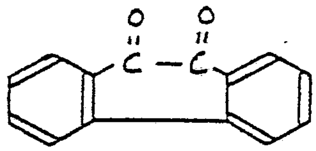

9,10-phenanthrenequinone

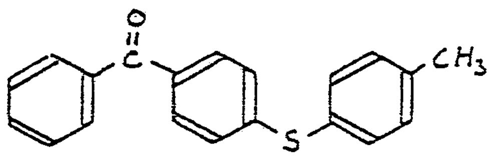

4-(methylbenzylthio)phenyl ketone

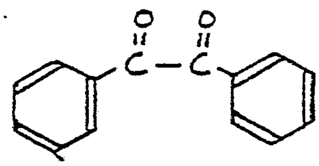

Benzil

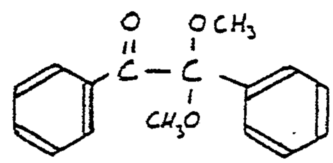

Benzildimethyl acetal

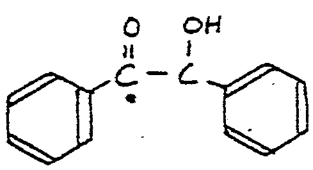

Benzoin

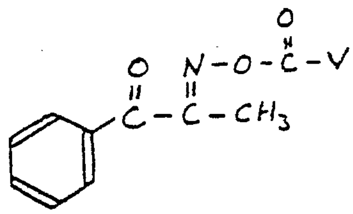

where V is 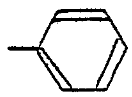 ie 1-phenyl-1,2-propanedione-2-O benzoyloxime or V is $-OC_2H_5$ ie 1-phenyl-1,2-propanedione-2-O-ethoxycarbonyl oxime.

Benzaldehyde is an example of an aldehyde photosensitiser and methyl ethyl ketone or diacetyl are typical of alphatic photosensitisers. Conventionally ultra violet light is regarded as having a wavelength of from 1 to 450 nm and for the purposes of this invention light having a wavelength of 200 to 450 nm is preferred so as to promote any diffraction around the metal particles which might occur.

The activator is a compound which creates free radicals suitable for initiating curing on receipt of energy transmitted from the photosensitiser. Usually the activator will contain an easily abstracted mobile hydrogen moiety attached to a carbon moiety adjacent a moiety more electronegative than carbon (for example nitrogen). Because the activator responds to broadly the same energy as the photosensitiser, the activater too is typically an amine, nitro or oxo compound, preferably aromatic. Accordingly

photosensitisers which can develop mobile free radicals (especially mobile hydrogen moieties) may act as self-photosensitising activators provided that the rate of production of mobile free radicals is sufficiently slower than the rate of transmission of energy throughout the ink or paint. However it is not always easy to ensure that a self-sensitising activator has a sufficiently slower rate of radical formation and so for this reason the activator may differ from the photosensitiser. The preferred activators are carboxylates and/or amines. Typical preferred activators are aminophenyl carboxylates or alkylamino (especially 3-dimethylamino) benzoates, for example

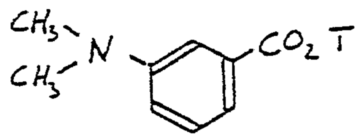

where T is $C_2H_5$- or $-CH_2CH_2OC_4H_9$ ie Ethyl or Butoxyethyl 3-(dimethylamino) phenyl carboxylates.

Other amine activators include $2,2^1$-dihydroxydiethylamine, dimethyl (2-hydroxyethyl)amine, tri (2-hydroxyethyl)amine, 3-(dimethylamino) benzaldehyde, 1,3-di(N-2-hydroxyethyl)-4-piperidyl)propane and 4-benzoyl-pyradine. Non-amines are chlorobenzophenone, $4,4^1$-bis(trichloromethyl)benzophenone, esters of 2-benzoyl benzoic acid, benzoyl biphenyl, 1-benzoyl napthalene, α,α-diethoxy acetophenone and 3-tertiary butyl-α,α,α-trichloro-

acetophenone. Examples of compounds which are both activators and sensitisers include Michler's ketone, 2-chlorothioxanthenone, 2-ethylanthra-quinone and 2-chloroanthraquinone.

The shelf-life of the curable ink or paint may be increased by adding a radical stabiliser in order to inhibit the slow creation of free radicals which may occur even in the absence of ultra violet light. Suitable stabilisers may have a quinenoid structure such as benzoquinone.

The curable prepolymer comprises monomer, dimer, trimer, oligomer or a mixture of two or more of these types which cure to a macromolecule on initiation by free radicals. Mixtures comprising oligomers, trimers and/or dimers are preferred because they are more easily obtained in forms sufficiently viscous for inks or paints. Viscosities of 50 to 200 centipoise are commonplace. Mixtures of two or more prepolymers will usually undergo copolymerisation (including addition copolymerisation, intercondensation and/or crosslinking) during curing to form a macromolecule composed of moieties originating from more than one species of prepolymer.

Suitable commercially available prepolymers include

monomers, dimers, trimers and oligomers of vinyl acetate, vinyl alcohol and preferably esters of acrylic (including methacrylic) acids. For example alkyl, hydroxyalkyl or alkanepolyol esters of mono-, di- or triacrylates or their methacrylate analogues may be used. Specific examples include hydroxybutyl acrylate, dicyclopentadiene acrylate, 1,6-hexanediol monoacrylate, cyclohexylacrylate, 1,6-hexanediol diacrylate, neopentyl glycol diacrylate, triethylene glycol diacrylate, ethylene glycol diacrylate, trimethylol propane diacrylate, tri(propylene glycol diacrylate), trimethylol propane triacrylate, pentaerythritol triacrylate and glycerol acrylates. Suitable higher molecular weight prepolymers include polyol acrylates, epoxy acrylates, polyester acrylates, polyether acrylates, melamine acrylates, urethan acrylates or acrylated alkylols and their methacrylate analogues. Specific examples include pentaerythritol tetracrylate, dipentaerythritol hexacrylate, ditrimethylol propane tetracrylate, epoxidised drying oil acrylate, aliphatic epoxy acrylates, oligoacrylates derived from bisphenols A or F and the condensates of a hydroxyl-containing acrylate, a di-isocyanate and a hydroxyl-containing moiety. Aromatic prepolymers may be modified by isocyanates to produce prepolymers such as aromatic urethan acrylates. Examples of prepolymers which can only be used in mixtures also comprising crosslinking prepolymers include polyamides which are usually crosslinked by means of amides such as N,N$^1$-methylene or N,N$^1$-hexamethylene bisacrylamide or bismethacrylamide. The propolymers may be used with coupling

agents such as N-vinyl-pyrrolidone or trimethylol propane.

The metal flakes are preferably made by flattening malleable metal spheres. The metal should possess good electrical conductivity and corrosion resistance and for this reason copper, aluminium, nickel, gold, platinum, palladium and especially silver are preferred. Alloys may be used. Prior to mixing with the prepolymer, the surface of the flake preferably carries a monomolecular layer of a surfactant such as the ester of a long (ie $C_{12}$ to $C_{30}$) chain carboxylic acid. Oleates, stearates and palmitrates are convenient. The surfactant assists in the performance of this invention by facilitating the close approach of metal flakes so enabling a chosen degree of conductivity to be achieved with fewer flakes and hence a lower screening effect. Because of the electron tunnel effect, adjacent flakes need not be contiguous. For commercial purposes the resistivity of the layer of cured ink or paint should be less than one ohm per square portion of the surface of the layer. The flakes may be adequately dispersed in the prepolymer by means of three roll milling.

The invention also provides a cured electrically conductive ink or paint comprising at least 8% by volume of metal flakes having the suitable dimensions as specified hereinbefore and containing a photoinitiator or its residues. The invention

further provides a component for an electrical circuit or an electrical circuit each comprising the cured electrically conductive ink.

The invention is illustrated by the following Examples.

EXAMPLES 1 TO 4

Two types of silver flake were made. Both types were 0.1 µm thick and a monomolecular layer of sodium stearate was applied to the surfaces of each. The other dimensions of the types are shown in Table 1.

TABLE 1

| Type | Maximum dimension of all the flakes: µm | Maximum dimension of all but 10% by number of the flakes |
|---|---|---|
| I | 20 µm | 10 µm |
| II | 30 µm | 20 µm |

Curable inks were made by mixing together the components specified below using a three roll mill. Each ink was printed onto glass using a silk screen comprising 120 (in Example 1) or 80 (in Examples 2, 3 and 4) threds/cm and passed 18 cm below a 78.7 watt/$cm^2$ lamp which irradiated it with ultra violet light in the wavelength range 404 to 436 nm in Examples 1 and 4 or 334 nm in Examples 2 and 3. The ink cured and its resistivity was measured. The results are shown in Table 2 where "pass speed"refers to the speed at which the printed glass was passed through the beam from the lamp.

TABLE 2

| Example | Pass Speed m/min | Resistivity ohm/square portion of cured ink surface |
|---|---|---|
| 1 | 7 | 0.47 |
| 2 | 4 | 0.4 |
| 3 | 18 | 0.5 |
| 4 | 18 | 0.9 |
| 5 | 0.9 | 0.06 |
| 6 | 0.9 | 0.05 |
| 7 | 0.9 | 0.18 |

Components of mixture:

Example 1

| | |
|---|---|
| 67.5% by wt | Type I silver flakes |
| 32.1% by wt | A proprietary photocurable prepolymer comprising a mixture of acrylate monomer, dimer and trimer and an activator all sold by Coates Bros Ltd as V4811 |
| 0.4% by wt | Ethyl anthraquinone (photosensitiser) |

Examples 2 and 3

| | |
|---|---|
| 51.0% by wt | Type II silver flakes |
| 47.0% by wt | The proprietary mixture as used in Example 1 |
| 1.0% by wt | Silica to confer thioxotropy |
| 1.0% by wt | Ethyl anthraquinone (photosensitiser) |

Example 4

| | |
|---|---|
| 51.0% by wt | Type II silver flakes |
| 30.0% by wt | Epoxy acrylate mixed with trimethyl propane triacrylate |
| 7.0% by wt | Tri(propylene glycol diacrylate) |
| 8.0% by wt | Butoxyethyl 3-(dimethylamino)phenyl carboxylate (activator) |
| 4% by wt | Isopropylxanthone (photosensitiser) |

EXAMPLES 5 TO 7

Further curable inks were made by mixing together the components specified below using a three roll mill. Each ink was

printed onto glass using a silk screen comprising 73.2 threds/cm and was passed 18 cm below a 200 watt medium pressure mercury lamp. The ink cured and its resistivity was measured. The resistivities obtained together with the pass speeds used are shown in Table 2.

Example 5

| | |
|---|---|
| 58% by wt | Type II silver flakes |
| 8.8% by wt | A proprietary photocurable triacrylate prepolymer sold by UCB as OTA480 |
| 17.7% by wt | A proprietary epoxy acrylate prepolymer sold by Rohm as Flex 6673 |
| 9.7% by wt | N-vinyl-pyrrolidone coupling agent for prepolymers |
| 2.2% by wt | Benzil dimethyl acetal (photosensitiser) |
| 3.6% by wt | Ethyl 3-dimethylamino-benzoate (activator) |

CLAIMS

1. A curable ink or paint comprising at least 8% by volume (based on the volume of the uncured ink or paint) of electrically conductive metal particles dispersed in one or more organic prepolymers which are curable by means of free radicals to produce an electrically conductive cured ink or paint wherein

(a) the metal particles have a thickness of less than 1 μm, a maximum dimension of less than 30 μm and not more than 10% by number of the flakes have a maximum dimension of above 20 μm,

(b) the ink or paint also comprises a photosensitiser which is reversibly convertible to an excited state on irradiation by ultra violet light and

(c) the ink or paint also comprises an activator which can be caused to create free radicals by the presence of the excited photosensitiser, whereby irradiation of the ink or paint with ultra violet

light excite the photosensitiser causing the activator to generate free radicals which cure the prepolymer.

2. An ink or paint as claimed in claim 1 wherein the photosensitiser is an aromatic oxo compound.

3. An ink or paint as claimed in claim 1 wherein the activator is an aromatic amine and/or carboxylate.

4. An ink or paint as claimed in claim 1 wherein the metal particles are in the form of flakes.

5. An ink or paint as claimed in any one of the preceding claims wherein the flakes are silver flakes.

6. An ink or paint as claimed in any one of the preceding claims wherein the prepolymer comprises an acrylate and/or a methacrylate.

7. An ink or paint as claimed in any one of the preceding claims which has been cured and contains a photosensitiser and/or a residue of a photosensitiser.

8. A component for an electrical circuit or an electrical circuit comprising a cured ink or paint as claimed in claim 7.

European Patent Office

# EUROPEAN SEARCH REPORT

0081323

Application number

EP 82 30 6293

## DOCUMENTS CONSIDERED TO BE RELEVANT

| Category | Citation of document with indication, where appropriate, of relevant passages | Relevant to claim | CLASSIFICATION OF THE APPLICATION (Int Cl 3) |
|---|---|---|---|
| A | US-A-3 968 056 (DONALD A.BOLON) *Column 8, claim 1; column 3, lines 5-13; column 3, line 58 - column 4, line 3* | 1,8 | H 01 B 1/22<br>C 09 D 11/00<br>C 09 D 5/24<br>H 05 K 3/12 |
| A | IEEE TRANS. ELECTRICAL INSULATION, vol. EI-13, no. 2, April 1978, pages 116-121; D.A.BOLON et al.: "Radiation curable conductive ink". *Abstract; page 116, right-hand column, last paragraph* | 1,8 | |
| A | FR-A-2 441 647 (FUJIKURA KASEI) | 1 | |
| | | | TECHNICAL FIELDS SEARCHED (Int. Cl. 3) |
| | | | C 09 D<br>H 01 B<br>H 05 K |

The present search report has been drawn up for all claims

| Place of search | Date of completion of the search | Examiner |
|---|---|---|
| THE HAGUE | 11-03-1983 | GIRARD Y.A. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons
& : member of the same patent family, corresponding document